# EUROPEAN PATENT APPLICATION

(11) **EP 4 765 630 A1**
(43) Date of publication of application: **24.06.2026**
(21) Application number: 24866992.1
(22) Date of filing: 01.07.2024
(51) Int. Cl.: H03F 1/02

(54) **AUXILIARY CIRCUIT APPLIED TO POWER AMPLIFIER, COMPENSATION METHOD, AND RELATED DEVICE**

(30) Priority: 18.09.2023 CN 202311204275
(71) Applicant: Zhejiang Starshine Semiconductor Co., Ltd., Wenzhou, Zhejiang 325025 (CN)
(72) Inventor: TIAN, Xu, Wenzhou, Zhejiang 325025 (CN); GAO, Anming, Wenzhou, Zhejiang 325025 (CN); ZHENG, Lei, Wenzhou, Zhejiang 325025 (CN); JIANG, Wei, Wenzhou, Zhejiang 325025 (CN)
(74) Representative: Piticco, Lorena
(86) International application number: PCT/CN2024/102840
(87) International publication number: WO 2025/060573

(57) **Abstract**

An auxiliary circuit applied to a power amplifier, a compensation method, and a related device. The auxiliary circuit comprises a self-bias circuit, and the self-bias circuit comprises a constant voltage source (100), a first amplifier transistor (HBT1), a second amplifier transistor (HBT2), and a first capacitor (C1). The backoff efficiency can be improved without affecting the saturation power of a power amplifier.

## Description

This application claims the priority to Chinese Patent Application No. 202311204275.2, titled "AUXILIARY CIRCUIT APPLIED TO POWER AMPLIFIER, COMPENSATION METHOD, AND RELATED DEVICE", filed on September 18, 2023 with the China National Intellectual Property Administration, which is incorporated herein by reference in its entirety.

### FIELD

The present disclosure relates to the technical field of electronic circuits, and in particular to an auxiliary circuit for a power amplifier, a method for compensating a power amplifier and related devices.

### BACKGROUND

With the development of wireless communication technologies and the gradual integration of communication products related to radio frequency into social life, the current design of radio frequency devices differs greatly from the past design of radio frequency devices. As an important device among radio frequency module products, a power amplifier (PA) is capable of increasing the power of a given input signal, thereby raising it to a load level for output devices such as transmitters.

With the advent of 4G LTE and 5G communication standards, variations occur in signal modulation methods, transitioning from constant-envelope modulation to envelope-variation modulation. This transition, aimed at maximizing system capacity, results in a high peak-to-average ratio for a transmission power of the signal, which requires the power amplifier to maintain linearity of PA over a certain range of power backoff. However, due to a low efficiency of conventional power amplifiers within the power backoff range, it is important to improve the efficiency of PA during power backoff.

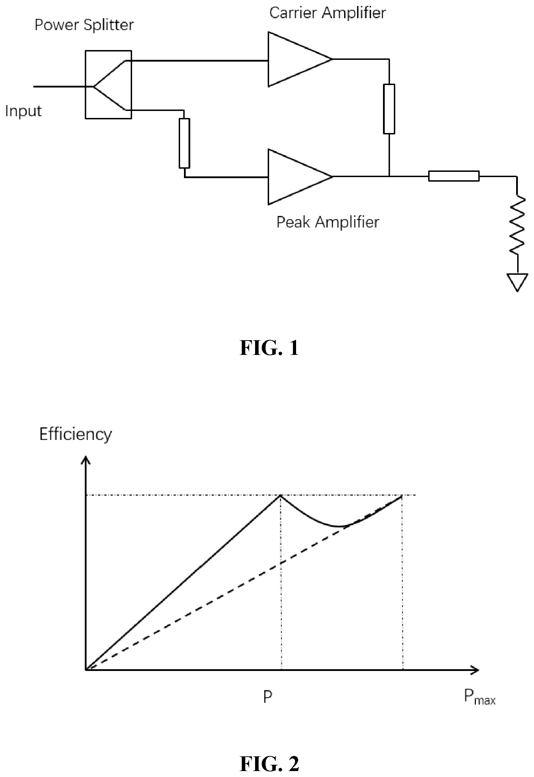

As a well-established technique for balancing linearity and enhancing power-added efficiency (PAE), the Doherty power amplifier offers a simple structure and high cost-effectiveness. The Doherty power amplifier includes two power amplifiers, a main amplifier (also known as carrier amplifier (CA)) and a peak amplifier (PK). The main amplifier operates in Class AB, while the peak amplifier operates in Class B or Class C. The two amplifiers do not operate simultaneously over the entire power range. Specifically, the main amplifier operates all the time, and the peak amplifier only operates when a set peak level is reached. In addition, a 1/4λ transmission line is provided for impedance transformation, ensuring that an apparent impedance of the main amplifier is reduced and an active load impedance is reduced when the peak amplifier operates. In addition, a front-end 1/4λ transmission line is provided for phase balancing between the two branches. A structure of a typical Doherty power amplifier is shown in FIG. 1.

In general, operating states of the Doherty power amplifier can be divided into three stages based on a magnitude of a signal. In a first stage, the peak amplifier does not operate and the main amplifier operates. In a second stage, the main amplifier saturates, the peak amplifier is activated, and the Doherty power amplifier transitions from a state of maximum efficiency to a state of maximum output. In a third stage, when the peak amplifier saturates, a maximum output power of the Doherty power amplifier is obtained, and high efficiency can be maintained under ideal conditions, as shown in FIG. 2.

Through research, it is found that the PA of the Doherty power amplifier commonly uses a 2Vbe bias architecture. The 2Vbe bias architecture provides excessive compensation current when the Doherty power amplifier operates at medium or low output power, thereby reducing a backoff efficiency of the power amplifier.

### SUMMARY

In view of this, an auxiliary circuit for a power amplifier, a method for compensating a power amplifier and related devices are provided according to embodiments of the present disclosure, to improve a backoff efficiency of the power amplifier.

To achieve the above objective, the present disclosure provides the following technical solutions.

An auxiliary circuit for a power amplifier, including a self-bias circuit connected to a main amplifier of the power amplifier.

The self-bias circuit includes: a constant voltage source, a first amplifier transistor, a second amplifier transistor, and a first capacitor.

A control terminal of the first amplifier transistor is connected to an output terminal of the constant voltage source, and the control terminal of the first amplifier transistor is further configured to receive a reference current. An input terminal of the first amplifier transistor is connected to a first power source.

A control terminal of the second amplifier transistor is connected to an output terminal of the first amplifier transistor, and the control terminal of the second amplifier transistor is further connected to a second terminal of the first capacitor. An input terminal of the second amplifier transistor is connected to a second power source. An output terminal of the second amplifier transistor serves as an output terminal of the self-bias circuit.

A first terminal of the first capacitor serves as an input terminal of the self-bias circuit.

In an embodiment, in the above auxiliary circuit for a power amplifier, the constant voltage source includes: a low-dropout-regulator-based power supply and a unidirectional device.

An output terminal of the low-dropout-regulator-based power supply is connected to an input terminal of the unidirectional device, and an output terminal of the unidirectional device serves as the output terminal of the constant voltage source.

In an embodiment, in the above auxiliary circuit for a power amplifier, in the constant voltage source: the low-dropout-regulator-based power supply is a fixed voltage supply or an adjustable voltage supply, and the unidirectional device is a diode or a transistor.

In response to the unidirectional device being a diode, an anode of the diode serves as the input terminal of the unidirectional device, and a cathode of the diode serves as the output terminal of the unidirectional device.

In response to the unidirectional device being a transistor, a base of the transistor serves as the input terminal of the unidirectional device, and an emitter of the transistor serves as the output terminal of the unidirectional device.

In an embodiment, the above auxiliary circuit for a power amplifier further includes: a fixed power-source bias circuit, configured to use the low-dropout-regulator-based power supply to provide a bias current for a peak amplifier in the power amplifier.

In an embodiment, in the above auxiliary circuit for a power amplifier, the fixed power-source bias circuit includes: a current mirror, a third amplifier transistor, and a fourth amplifier transistor.

An input terminal of the current mirror is connected to the output terminal of the low-dropout-regulator-based power supply.

A control terminal of the third amplifier transistor is connected to an output terminal of the current mirror, and an input terminal of the third amplifier transistor is connected to the first power source.

A control terminal of the fourth amplifier transistor is connected to an output terminal of the third amplifier transistor. An input terminal of the fourth amplifier transistor is connected to the second power source. An output terminal of the fourth amplifier transistor serves as an output terminal of the fixed power-source bias circuit.

A method for compensating a power amplifier, including: determining whether the power amplifier enters a saturation state; and controlling, in response to the power amplifier entering the saturation state, a preset constant current source to output a compensation current to a main amplifier in the power amplifier.

In an embodiment, for the above method for compensating a power amplifier, after the controlling a preset constant current source to output a compensation current to a main amplifier in the power amplifier, the method includes: acquiring a mirror current of the current outputted from the constant current source; and determining the mirror current as a compensation current for a peak amplifier in the power amplifier.

A power amplifier including the auxiliary circuit for a power amplifier according to any one of the above technical solutions.

In an embodiment, for the above power amplifier, the power amplifier further includes: a 90° directional coupler and an isolation circuit.

An input of the 90° directional coupler serves as an input of the power amplifier. A first output of the 90° directional coupler is connected to a main amplifier branch. A second output of the 90° directional coupler is connected to a peak amplifier branch.

The main amplifier branch includes, in sequence from an input to an output of the main amplifier branch, at least a first matching network and the self-bias circuit.

The peak amplifier branch includes, in sequence from an input to an output of the peak amplifier branch, at least a second matching network, the fixed power-source bias circuit, and a 90° phase-shift circuit.

An input of the isolation circuit is connected to both the output of the main amplifier branch and the output of the peak amplifier branch, and an output of the isolation circuit serves as an output of the power amplifier.

An electronic device including the power amplifier according to any one of the above technical solutions. Based on the above technical solutions, an auxiliary circuit for a power amplifier, a power amplifier, and an electronic device are provided according to the embodiments of the present disclosure. The auxiliary circuit includes a self-bias circuit. The self-bias circuit includes a constant voltage source, a first amplifier transistor, a second amplifier transistor, and a first capacitor. In response to detecting that the power amplifier enters a saturation state, the first amplifier transistor is turned on, and a compensation current is provided to the main amplifier in the power amplifier through the first amplifier transistor. With this design, in response to the power amplifier entering the saturation state, the circuit is automatically activated to provide a compensation current to the main amplifier, thereby improving the backoff efficiency without reducing a saturation power of the power amplifier.

### BRIEF DESCRIPTION OF THE DRAWINGS

To clearly illustrate technical solutions in embodiments of the present disclosure or in the related technology, drawings referred to describe the embodiments or the related art are briefly described hereinafter. Apparently, the drawings in the following description show only some embodiments of the present disclosure, and for those skilled in the art, other drawings may be obtained based on these drawings without any creative effort.
FIG. 1 is a schematic structural diagram of a typical Doherty power amplifier;
FIG. 2 is a schematic diagram of an operating state of a typical Doherty power amplifier;
FIG. 3 is a schematic diagram of a 2Vbe bias structure;
FIG. 4 is a schematic structural diagram of a self-bias circuit in an auxiliary circuit according to an embodiment of the present disclosure;
FIGS. 5 and 6 are schematic diagrams of simulation results of a power amplifier to which the self-bias circuit shown in FIG. 5 is applied;
FIG. 7 is a schematic structural diagram of a self-bias circuit and a fixed power-source bias circuit in an auxiliary circuit according to an embodiment of the present disclosure;
FIGS. 8, 9 and 10 are schematic diagrams of simulation results of a power amplifier to which the fixed power-source bias circuit is applied;
FIG. 11 is a flowchart of a method for compensating a power amplifier according to an embodiment of the present disclosure;
FIG. 12 is a flowchart of a method for compensating a power amplifier according to another embodiment of the present disclosure;
FIG. 13 is a schematic diagram of a power amplifier circuit according to an embodiment of the present disclosure;
FIG. 14 is a schematic structural diagram of parts A and B in FIG. 13;
FIG. 15 is a schematic structural diagram of a 90° directional coupler;
FIG. 16 is a schematic diagram of a power amplifier circuit according to another embodiment of the present disclosure;
FIG. 17 is a schematic structural diagram of a power splitter; and
FIG. 18 is a schematic structural diagram of a 90° phase-shift circuit according to an embodiment of the present disclosure.

### DETAILED DESCRIPTION

The technical solutions in the embodiments of the present disclosure are described clearly and completely as follows in conjunction with the drawings of the embodiments of the present disclosure. Apparently, the described embodiments are only some of the embodiments of the present disclosure, rather than all of the embodiments. All other embodiments obtained by those skilled in the art based on the embodiments in the present disclosure without any creative effort fall within the protection scope of the present disclosure.

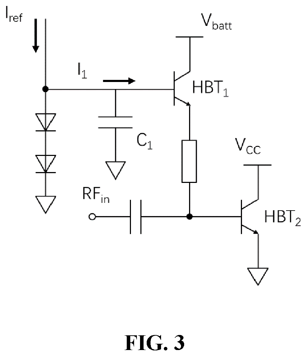

In the related art, a power amplifier typically employs a 2Vbe bias structure (corresponding to a part CA in Doherty architecture). A circuit diagram of the structure is shown in FIG. 3. The structure includes two diodes, two capacitors, two amplifier transistors and a voltage-drop resistor. Specific connections of the structure and interconnections among the devices are shown in FIG. 3. This structure provides excessive compensation current when the power amplifier operates at medium or low output power, thereby reducing the backoff efficiency of the power amplifier. A specific process is described as follows. Since the capacitor C1 in FIG. 3 provides a low radio-frequency impedance at a base of the amplifier transistor HBT1 and thus the base is approximately grounded, a portion of the power from an input signal RFin is applied across a base-emitter (BE) junction of the amplifier transistor HBT1. In this case, due to a rectifying characteristic of a PN junction of an amplifier transistor, an equivalent direct-current voltage drop is generated for Vbe of the amplifier transistor HBT1. This voltage drop prevents Vbe of the amplifier transistor HBT2 from decreasing. Thus, a bias circuit can be provided to provide a current to the amplifier transistor HBT2 to stabilize nonlinearity of the HBT2. In this context, as an input power increases, I1 rises accordingly. Such bias circuit is referred to as a self-bias circuit. Based on this, an auxiliary circuit that can be applied to a power amplifier is designed according to the present disclosure. The auxiliary circuit includes a self-bias circuit. The self-bias circuit can be included in a main amplifier of the power amplifier, and is a part of the main amplifier. The self-bias circuit is configured to provide a compensation current to the main amplifier in the power amplifier in response to detecting that the power amplifier enters a saturation state. With this design, in response to the power amplifier entering the saturation state (when the power amplifier operates at medium-to-high output power), the self-bias circuit is automatically activated to provide a compensation current to the main amplifier, thereby improving the backoff efficiency without reducing a saturation power of the power amplifier.

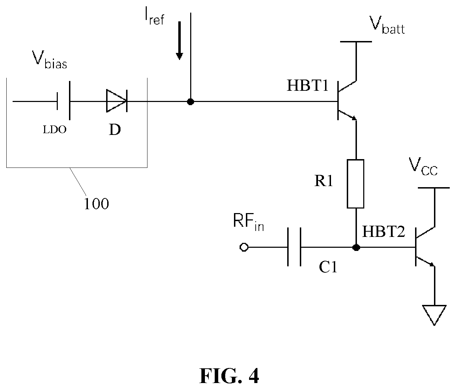

In an embodiment, referring to FIG. 4, the self-bias circuit according to an embodiment of the present disclosure includes: a constant voltage source 100, a first amplifier transistor HBT1, a second amplifier transistor HBT2, and a first capacitor C1.

Connections among the above-mentioned elements are as follows.

A control terminal of the first amplifier transistor HBT1 is connected to an output terminal of the constant voltage source 100, and the control terminal of the first amplifier transistor HBT1 is further configured to receive a reference current I_{ref}. An input terminal of the first amplifier transistor HBT1 is connected to a first power source V_{batt}.

A control terminal of the second amplifier transistor HBT2 is connected to an output terminal of the first amplifier transistor HBT1, and the control terminal of the second amplifier transistor HBT2 is further connected to a second terminal of the first capacitor C1. An input terminal of the second amplifier transistor HBT2 is connected to a second power source V_{CC}. An output terminal of the second amplifier transistor HBT2 serves as an output terminal of the self-bias circuit. The output terminal of the self-bias circuit is connected to a main amplifier branch.

A first terminal of the first capacitor C1 serves as an input terminal of the self-bias circuit. The input terminal of the self-bias circuit is also connected to the main amplifier branch, and is located upstream of the output terminal of the self-bias circuit. The input terminal of the self-bias circuit is configured to acquire a signal RFᵢₙ. The RFᵢₙ is an electrical signal for the main amplifier branch of the power amplifier or an input signal of the main amplifier.

Further, referring to FIG. 4, a first voltage-drop resistor R1 may be further provided between the first switching transistor HBT1 and the second amplifier transistor HBT2 in this solution, to ensure the safety of electronic components in the circuit and prevent the amplifier transistors in the circuit from high-voltage breakdown. The first voltage-drop resistor R1 drops a voltage associated with the output current of the first amplifier transistor HBT1, to ensure the safety of downstream electronic components.

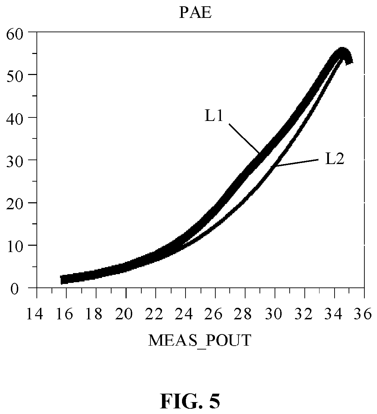

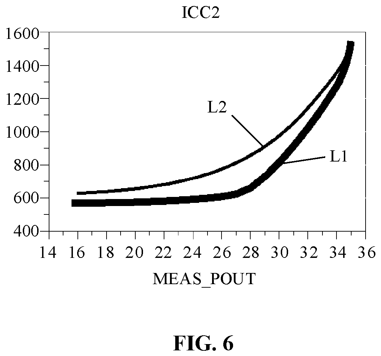

In the embodiment shown in FIG. 4, when the power amplifier PA enters the saturation state, a node voltage drops. Through the constant voltage source 100, a bias current is provided to the first amplifier transistor and the second amplifier transistor for current compensation, to enhance a response speed of the amplifier transistors, thereby improving the efficiency of the power amplifier PA under a power backoff condition. In addition, power consumption due to excess current of the amplifier transistors is reduced. To verify the effectiveness, a simulation comparison between the present solution and the existing solution is performed in the present disclosure, to obtain simulation results shown in FIGS. 5 and 6. In FIGS. 5 and 6, a curve L1 is a simulation curve of the power amplifier according to the related art, and a curve L2 is a simulation curve of the power amplifier according to the technical solution of the present disclosure. In the schematic diagrams of the simulation results shown in FIGS. 5 and 6, the horizontal axis represents an output power of the power amplifier. The vertical axis in FIG. 5 represents an output efficiency (that is, the PAE) of the power amplifier, and the vertical axis in FIG. 6 represents an output current of the power amplifier. Through further analysis of the simulation results presented in FIGS. 5 and 6, it can be clearly observed that with the technical solution of the present disclosure, the power consumption due to the excess current of the power amplifier is reduced and the back-off efficiency of the power amplifier is improved.

Further, in the self-bias circuit disclosed in the above embodiment, the constant voltage source 100 can be a constant voltage source of any structure type in the related art as long as it can output a constant target voltage. For example, referring to FIG. 4, in this embodiment, the constant voltage source 100 in the self-bias circuit includes a low-dropout-regulator (LDO)-based power supply and a unidirectional device. The unidirectional device is configured to prevent a reverse current. An output terminal of the low-dropout-regulator-based power supply is connected to an input terminal of the unidirectional device, and an output terminal of the unidirectional device serves as the output terminal of the constant voltage source 100. Further, the low-dropout-regulator-based power supply may be a fixed voltage supply or an adjustable voltage supply. When the low-dropout-regulator-based power supply is an adjustable voltage supply, a user can regulate an output voltage of the low-dropout-regulator-based power supply according to design requirements. The unidirectional device may be a diode or a transistor. In response to the unidirectional device being a diode D as shown in FIG. 4, an anode of the diode D serves as the input terminal of the unidirectional device, and a cathode of the diode D serves as the output terminal of the unidirectional device. In response to the unidirectional device being a transistor, a base of the transistor serves as the input terminal of the unidirectional device, and an emitter of the transistor serves as the output terminal of the unidirectional device. When the power amplifier enters the saturation state, the node voltage of the power amplifier drops. At this time, the diode or the transistor in the constant voltage source 100 is turned on (for the transistor, the base and the emitter of the transistor are electrically connected), and the low-dropout-regulator-based power supply provides a bias current to the main amplifier for compensation.

Through further research, it is found that in the Doherty power amplifier architecture in the related art, an issue exists that the peak amplifier PK is difficult to turn on at the same time as the carrier amplifier CA reaches the onset of saturation, thereby degrading the efficiency of the power amplifier.

In this solution, based on a fixed power-source bias circuit, the low-dropout-regulator-based power supply can be configured as a bias current source for the peak amplifier in the power amplifier, and the low-dropout-regulator-based power supply can be used to provide a bias current to the peak amplifier. In this way, after the carrier amplifier CA reaches saturation, a current is generated in the fixed power-source bias circuit (which is used to provide a compensation current to the peak amplifier), and the peak amplifier PK is turned on accordingly. In an embodiment, in this solution, the current in a bias branch of the constant voltage source 100 is injected into the peak amplifier PK by using a current mirror C.M.

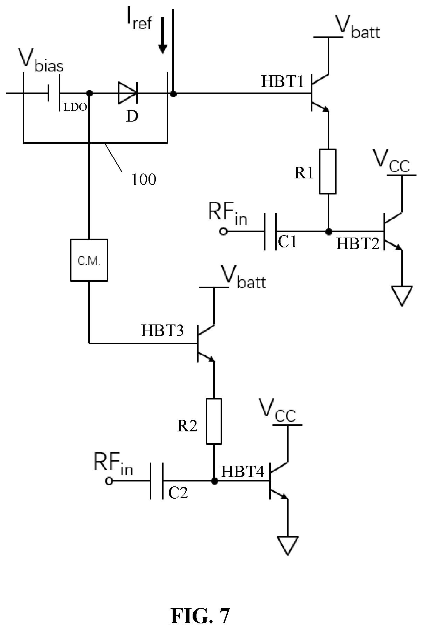

In an embodiment, referring to FIG. 7, the auxiliary circuit further includes a fixed power-source bias circuit. The fixed power-source bias circuit includes: a current mirror C.M, a third amplifier transistor HBT3, and a fourth amplifier transistor HBT4.

An input terminal of the current mirror C.M is connected to the output terminal of the low-dropout-regulator-based power supply. The current mirror C.M is configured to perform a mirroring operation on the current outputted by the low-dropout-regulator-based power supply to obtain a mirror current, and provide the mirror current to a control terminal of the third amplifier transistor HBT3.

The control terminal of the third amplifier transistor HBT3 is connected to an output terminal of the current mirror C.M, and an input terminal of the third amplifier transistor HBT3 is connected to the first power source V_{batt}.

A control terminal of the fourth amplifier transistor HBT4 is connected to an output terminal of the third amplifier transistor HBT3. An input terminal of the fourth amplifier transistor HBT4 is connected to the second power source VCC. An output terminal of the fourth amplifier transistor HBT4 serves as an output terminal of the fixed power-source bias circuit. The output terminal of the fixed power-source bias circuit is connected to a peak amplifier branch.

In the above solution, when a mirror circuit mirrors the output current of the constant voltage source 100 to the control terminal of the third amplifier transistor HBT3 via the current mirror C.M, the third amplifier transistor HBT3 is turned on, and the output current of the first power source Vbatt is applied to the control terminal of the fourth amplifier transistor HBT4. Thus, the fourth amplifier transistor HBT4 is turned on, and the output current of the second power source V_{CC} is outputted though the output terminal of the fourth amplifier transistor HBT4.

Further, referring to FIG. 7, a second voltage-drop resistor R2 is further provided in the configuration of the fixed power-source bias circuit, to ensure the safety of electronic components in the fixed power-source bias circuit. The second voltage-drop resistor R2 is provided between the third amplifier transistor HBT3 and the fourth amplifier transistor HBT4, and is configured to drop a voltage associated with the output current of the third amplifier transistor HBT3.

Further, for the fixed power-source bias circuit, referring to FIG. 7, a second capacitor C2 may be connected to the control terminal of the third amplifier transistor HBT3 in this solution, to prevent an interference signal in the current outputted by the current mirror from interfering normal on-off of the third amplifier transistor HBT3. One terminal of the second capacitor C2 is connected to the control terminal of the third amplifier transistor HBT3, and the other terminal of the second capacitor C2 is grounded. For the input current of the control terminal of the third amplifier transistor HBT3, the voltage at the control terminal is stabilized by the second capacitor C2, to ensure reliable operation of the third amplifier transistor HBT3.

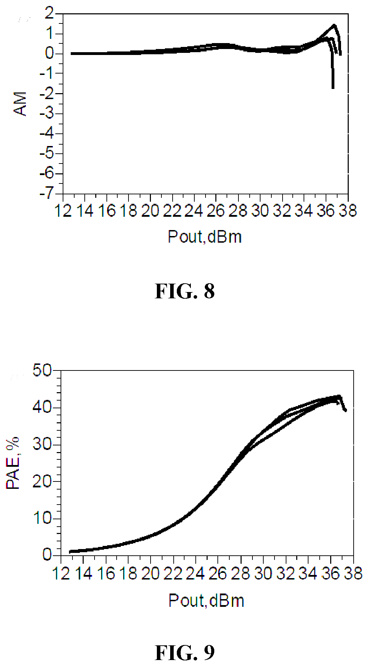

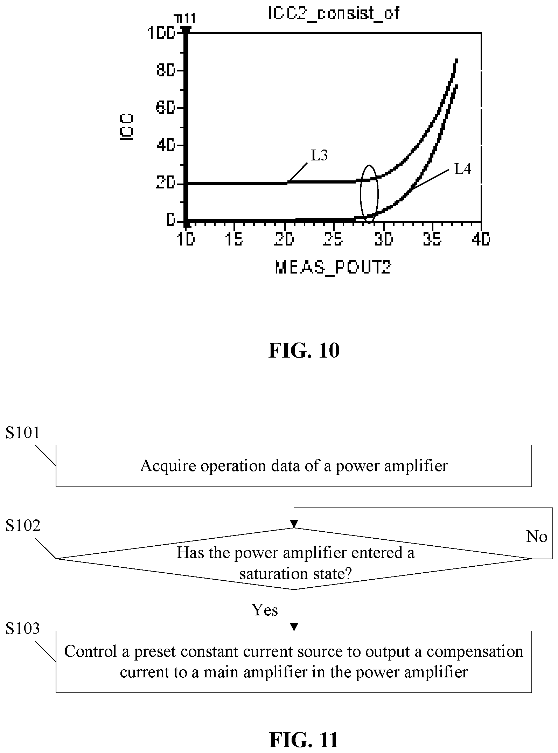

By employing the fixed-power source bias circuit, the peak amplifier PK can be accurately turned on at the moment when the carrier amplifier CA reaches saturation. This solution is compatible with APT applications while ensuring the backoff efficiency, and is suitable for low-current scenarios. The simulation results are shown in FIG. 8, FIG. 9 and FIG. 10. The curves shown in FIG. 8, FIG. 9 and FIG. 10 are the simulation curves for the technical solution disclosed in the present disclosure. In FIGS. 8 to 10, the horizontal axis represents an output power. In FIG. 8, the vertical axis represents gain magnitude. In FIG. 9, the vertical axis represents an efficiency, which reflects the performance of the power amplifier. In FIG. 10, the vertical axis represents a current, L3 represents the current of the carrier amplifier CA, and L4 represents the current of the peak amplifier PK. As observed from FIGS. 8, 9, and 10, the activation of the peak amplifier is precise and timely.

Corresponding to the auxiliary circuit, a method for compensating a power amplifier is provided according to the present disclosure. The method for compensating a power amplifier can be applied to a power amplifier provided with the auxiliary circuit according to any one of the above embodiments. The method for compensating a power amplifier according to an embodiment of the present disclosure is implemented through the auxiliary circuit. In addition, other circuit structures can be employed to implement the method for compensating a power amplifier disclosed in the embodiment of the present disclosure. Any circuit structure operable to implement the method for compensating a power amplifier disclosed in the embodiment of the present disclosure falls within the scope of the present disclosure. In an embodiment, referring to FIG. 11, the method for compensating a power amplifier includes steps S101 to S103.

In step S101, operation data of a power amplifier is acquired.

In step S102, whether the power amplifier enters a saturation state is determined based on the operation data of the power amplifier.

In step S103, in response to the power amplifier entering the saturation state, a preset constant current source is controlled to output a compensation current to a main amplifier in the power amplifier.

Taking the auxiliary circuit disclosed in the embodiments of the present disclosure as an example, by appropriately setting the reference current I_{ref}, steps S102 and S103 can be automatically implemented by the self-bias circuit in the auxiliary circuit.

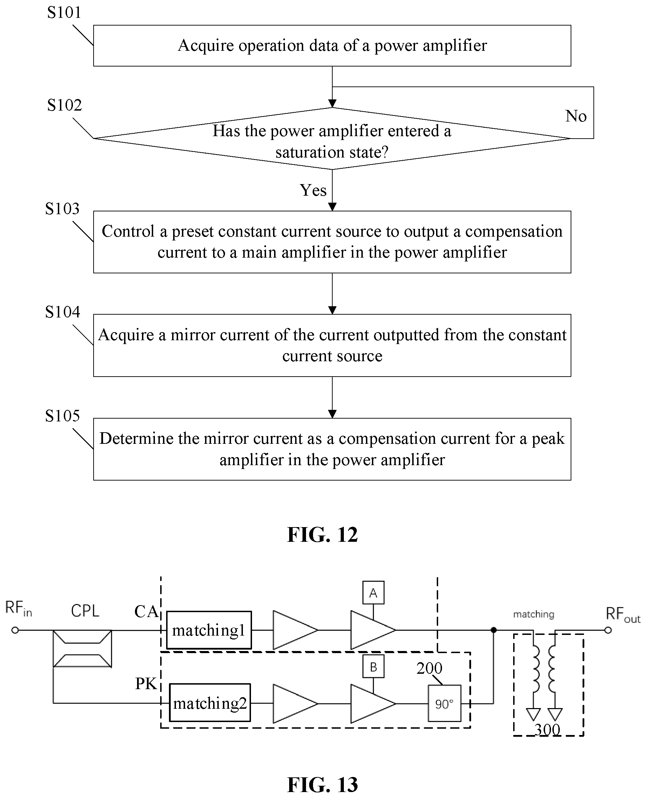

Corresponding to the fixed power-source bias circuit, referring to FIG. 12, after the preset constant current source is controlled to output a compensation current to a main amplifier in the power amplifier, the method for compensating a power amplifier further includes steps S104 and S105.

In step S104, a mirror current of the current outputted from the constant current source is acquired.

In step S105, the mirror current is determined as a compensation current for a peak amplifier in the power amplifier.

Taking the auxiliary circuit disclosed in the embodiments of the present disclosure as an example, steps S104 and S105 can be automatically implemented by the fixed power-source bias circuit in the auxiliary circuit. Corresponding to the above solution, a power amplifier is further provided according to the present disclosure. The power amplifier includes the auxiliary circuit for a power amplifier according to any one of the above embodiments. By applying the self-bias circuit and the fixed power-source bias circuit in the auxiliary circuit to the power amplifier, the power amplifier can operate with high backoff efficiency, and the peak amplifier can be activated precisely when the carrier amplifier of the power amplifier reaches the onset of saturation.

In an embodiment, referring to FIG. 13, the power amplifier according to the embodiment of the present disclosure includes a 90° directional coupler CPL and an isolation circuit 300.

An input of the 90° directional coupler serves as an input of the power amplifier. A first output of the 90° directional coupler is connected to a main amplifier branch. A second output of the 90° directional coupler is connected to a peak amplifier branch.

The main amplifier branch includes the carrier amplifier CA in the present disclosure. The main amplifier branch includes, in sequence from an input to an output of the main amplifier branch, at least a first matching network (matching1) and the self-bias circuit. In this solution, the specific structure and type of the matching network can be set according to user requirements.

The peak amplifier branch includes, in sequence from an input to an output of the peak amplifier branch, at least a second matching network (matching2), the fixed power-source bias circuit, and a 90° phase-shift circuit 200.

An input of the isolation circuit is connected to both the output of the main amplifier branch and the output of the peak amplifier branch, and an output of the isolation circuit serves as an output of the power amplifier.

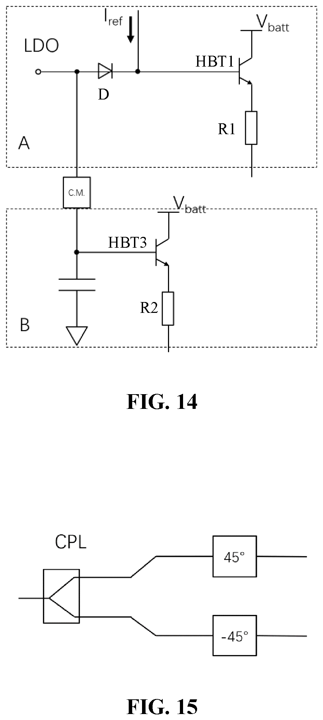

Reference is made to FIGS. 14 and 13. In FIG. 13, part A represents the constant voltage source 100, the unidirectional device, the first amplifier transistor HBT1, and the first voltage-drop resistor R1 in the self-bias circuit. The first capacitor C1 and the second amplifier transistor HBT2 in the self-bias circuit are directly connected in the main amplifier branch. Part B represents the mirror circuit, the third amplifier transistor HBT3, and the second voltage-drop resistor R2 in the fixed power-source bias circuit, and the second resistor and the fourth amplifier transistor HBT4 in the fixed power-source bias circuit are directly connected in the peak amplifier branch.

The 90° directional coupler CPL may be implemented using a conventional coupler, and the structural principle thereof is illustrated in FIG. 15.

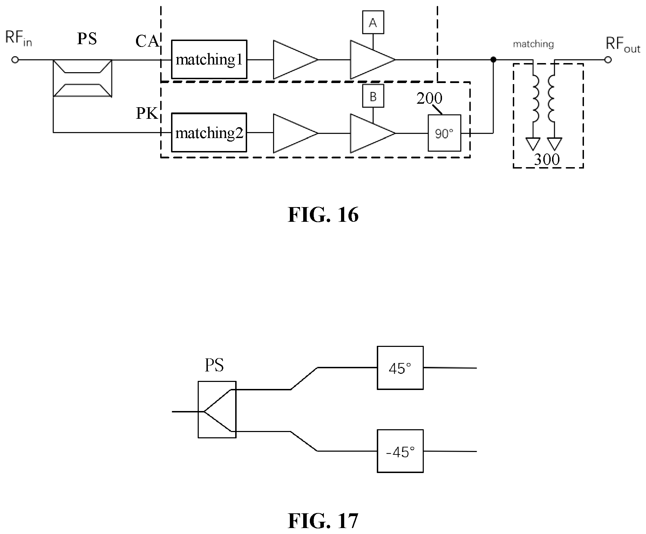

In addition to using the 90° directional coupler CPL for splitting a current, the power amplifier shown in FIG. 13 can also employ a power splitter (PS) instead of the 90° directional coupler CPL, as shown in FIGS. 16 and 17. The power splitter is a device that divides the energy of one input signal into two or more output signals with equal or unequal energy, while ensuring a certain degree of isolation among its output ports. In this case, an input of the power splitter PS serves as the input of the power amplifier, the first output of the 90° directional coupler is connected to the main amplifier branch, and a second output of the power splitter PS is connected to the peak amplifier branch. After the 90° directional coupler CPL is replaced by the power splitter PS, the isolation degree between two ports (the input port corresponding to the main amplifier branch and the input port corresponding to the peak amplifier branch) is improved, preventing mutual interference between the two signals, and avoiding abnormal oscillations in PA during operation.

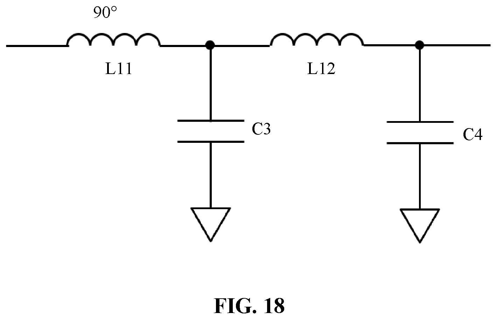

In addition, a specific structure of the 90° phase-shift circuit can be independently designed according to user's requirements. The 90° phase-shift circuit includes at least one series-connected passive device and at least one parallel-connected passive device. The passive device can be a capacitor or an inductor. Besides the above passive devices, other auxiliary components can be included to ensure the reliability of the circuit. In this regard, the specific design form of the 90° phase-shift circuit is further provided according to the present disclosure. The specific design form represents merely a preferred implementation, and further optimizations to this structure are also within the protection scope of the present disclosure. Referring to FIG. 18, the 90° phase-shift circuit according to an embodiment of the present disclosure includes: a first inductor L11, a second inductor L12, a third capacitor C3, and a fourth capacitor C4.

A first terminal of the first inductor L11 serves as an input terminal of the 90° phase-shift circuit, and a second terminal of the first inductor L11 is connected to a first terminal of the second inductor L12.

A second terminal of the second inductor L12 serves as an output terminal of the 90° phase-shift circuit.

A first terminal of the third capacitor C3 is connected to the first terminal of the second inductor L12, and a second terminal of the third capacitor C3 is grounded.

A first terminal of the fourth capacitor C4 is connected to the second terminal of the second inductor L12, and a second terminal of the fourth capacitor C4 is grounded.

With the first inductor L11, the second inductor L12, the third capacitor C3, and the fourth capacitor C4C4, a phase-shift operation of an input signal can be implemented. By configuring specific parameters of the first inductor L11, the second inductor L12, the third capacitor C3, and the fourth capacitor C4, a phase of the input signal can be shifted by 90°.

The power amplifier disclosed in the above-described embodiments of the present disclosure may be a Doherty power amplifier.

Corresponding to the above power amplifier, an electronic device is further provided according to the present disclosure. The electronic device includes the power amplifier according to any one of the above embodiments. In an embodiment, the electronic device may be a terminal device such as a mobile phone, a computer, a PC, or a tablet.

For the convenience of description, the above system is described as various modules with different functions. Apparently, in some implementations of the present disclosure, the functions of the modules can be implemented in the same one or more software and/or hardware.

Various embodiments in this specification are described in a progressive manner. The same and similar parts between the embodiments may be referred to each other, and each of the embodiments focuses on differences from other embodiments. In particular, the system or embodiments of the system is similar to embodiments of the method, thus is described simply, and may be referred to relevant parts of the embodiments of the method. The system and the embodiments of the system described above are only illustrative. Units described as a discrete component may or may not be physically separated. Components shown as units may or may not be physical units, that is, the components may be located in one place or may be distributed among multiple network units. Some or all modules thereof may be selected based on an actual requirement, to implement the solution in the embodiments. Those skilled in the art can understand and implement the present disclosure without any creative effort.

Those skilled in the art should further understand that, units and algorithm steps described in conjunction with the embodiments disclosed herein may be realized by electronic hardware, computer software or a combination thereof. To clearly illustrate interchangeability of the hardware and the software, the composition and steps of each of the embodiments are generally described above based on functions. Whether these functions are executed by hardware or software depends on the specific applications and design constraints of the technical solution. Those skilled in the art may implement the described functions in various manners for each specific application.

The steps of the method or algorithm described in conjunction with the embodiments of the present disclosure may be implemented by hardware, a software module executed by a processor, or a combination thereof. The software module may be stored in a random-access memory (RAM), a memory, a read only memory (ROM), an electrically programmable ROM, an electrically-erasable programmable ROM, a register, a hard disk, a removable disk drive, a CD-ROM, or any other storage medium known in the art.

It should be further illustrated that a relation term such as "first" and "second" herein is only used to distinguish one entity or operation from another entity or operation, and does not necessarily require or imply that an actual relation or sequence exists between these entities or operations. In addition, terms "include", "comprise" or any other variants thereof refer to non-exclusive inclusion, such that a process, a method, an article or a device including a series of elements includes the elements and other elements that are not explicitly listed, or further includes other inherent elements of the process, method, article or device. Unless expressively limited, the statement "including a..." does not exclude the case that other similar elements may exist in the process, the method, the article, or the device other than enumerated elements.

The above description of the embodiments herein enables those skilled in the art to implement or use the present disclosure. Various modifications to these embodiments are apparent to those skilled in the art. The general principles defined herein may be implemented in other embodiments without departing from the spirit or scope of the present disclosure. Therefore, the present disclosure is not limited to the embodiments described herein, but should comply with the widest scope consistent with the principles and novel features disclosed herein.

## Claims

1. An auxiliary circuit for a power amplifier, comprising a self-bias circuit connected to a main amplifier of the power amplifier, wherein
the self-bias circuit comprises a constant voltage source, a first amplifier transistor, a second amplifier transistor, and a first capacitor,
a control terminal of the first amplifier transistor is connected to an output terminal of the constant voltage source, the control terminal of the first amplifier transistor is further configured to receive a reference current, and an input terminal of the first amplifier transistor is connected to a first power source,
a control terminal of the second amplifier transistor is connected to an output terminal of the first amplifier transistor, the control terminal of the second amplifier transistor is further connected to a second terminal of the first capacitor, an input terminal of the second amplifier transistor is connected to a second power source, and an output terminal of the second amplifier transistor serves as an output terminal of the self-bias circuit, and
a first terminal of the first capacitor serves as an input terminal of the self-bias circuit.

2. The auxiliary circuit for a power amplifier according to claim 1, wherein the constant voltage source comprises:
a low-dropout-regulator-based power supply and a unidirectional device,
an output terminal of the low-dropout-regulator-based power supply is connected to an input terminal of the unidirectional device, and an output terminal of the unidirectional device serves as the output terminal of the constant voltage source.

3. The auxiliary circuit for a power amplifier according to claim 2, wherein in the constant voltage source:
the low-dropout-regulator-based power supply is a fixed voltage supply or an adjustable voltage supply, and
the unidirectional device is a diode or a transistor, wherein
in response to the unidirectional device being a diode, an anode of the diode serves as the input terminal of the unidirectional device, and a cathode of the diode serves as the output terminal of the unidirectional device, and
in response to the unidirectional device being a transistor, a base of the transistor serves as the input terminal of the unidirectional device, and an emitter of the transistor serves as the output terminal of the unidirectional device.

4. The auxiliary circuit for a power amplifier according to claim 1, further comprising: a fixed power-source bias circuit, configured to configure a bias current source for a peak amplifier in the power amplifier as the low-dropout-regulator-based power supply.

5. The auxiliary circuit for a power amplifier according to claim 4, wherein the fixed power-source bias circuit comprises:
a current mirror, a third amplifier transistor, and a fourth amplifier transistor, wherein
an input terminal of the current mirror is connected to the output terminal of the low-dropout-regulator-based power supply,
a control terminal of the third amplifier transistor is connected to an output terminal of the current mirror, and an input terminal of the third amplifier transistor is connected to the first power source, and
a control terminal of the fourth amplifier transistor is connected to an output terminal of the third amplifier transistor, an input terminal of the fourth amplifier transistor is connected to the second power source, and an output terminal of the fourth amplifier transistor serves as an output terminal of the fixed power-source bias circuit.

6. A method for compensating a power amplifier, comprising:
determining whether the power amplifier enters a saturation state; and
controlling, in response to the power amplifier entering the saturation state, a preset constant current source to output a compensation current to a main amplifier in the power amplifier.

7. The method for compensating a power amplifier according to claim 6, wherein after the controlling a preset constant current source to output a compensation current to a main amplifier in the power amplifier, the method comprises:
acquiring a mirror current of the current outputted from the constant current source; and
determining the mirror current as a compensation current for a peak amplifier in the power amplifier.

8. A power amplifier, comprising the auxiliary circuit for a power amplifier according to any one of claims 1 to 6.

9. The power amplifier according to claim 7, wherein when the auxiliary circuit is the auxiliary circuit according to claim 6, the power amplifier further comprises a 90° directional coupler and an isolation circuit, wherein
an input of the 90° directional coupler serves as an input of the power amplifier, a first output of the 90° directional coupler is connected to a main amplifier branch, and a second output of the 90° directional coupler is connected to a peak amplifier branch,
the main amplifier branch comprises, in sequence from an input to an output of the main amplifier branch, at least a first matching network and the self-bias circuit,
the peak amplifier branch comprises, in sequence from an input to an output of the peak amplifier branch, at least a second matching network, the fixed power-source bias circuit, and a 90° phase-shift circuit, and
an input of the isolation circuit is connected to both the output of the main amplifier branch and the output of the peak amplifier branch, and an output of the isolation circuit serves as an output of the power amplifier.

10. An electronic device, comprising the power amplifier according to any one of claims 8 to 9.
